# EUROPEAN PATENT APPLICATION

(11) **EP 4 645 699 A2**
(43) Date of publication of application: **05.11.2025**
(21) Application number: 25197326.9
(22) Date of filing: 23.08.2023
(51) Int. Cl.: H03K 17/965

(54) **DEVICE FOR THE DETECTION OF ACTUATING OPERATIONS ON MOTOR VEHICLES**

(62) Divisional of application: 23192840.9
(71) Applicant: HUF Hülsbeck & Fürst GmbH & Co. KG, 42551 Velbert (DE)
(72) Inventor: MAGDA, Daniel, 42551 Velbert (DE); BECHEANU, Valentin, 42551 Velbert (DE); IONESCU, Andrei, 42551 Velbert (DE)
(74) Representative: Zenz Patentanwälte Partnerschaft mbB

(57) **Abstract**

A Device for detecting an actuating action on motor vehicles, the device having an actuation element (2; 21), a sensor arrangement and an evaluation device (4; 24) which is coupled to the sensor arrangement and outputs an actuation signal as a function of signals from the sensor arrangement. The sensor arrangement is arranged on the actuation element (2; 21) in order to detect a deformation of the actuation element (2; 21) during an actuation.

The sensor arrangement comprising at least one strain gauge (5, 6; 23a, 23b) which is fixed to the actuation element in order to detect deformations and the evaluation device (4; 24) is designed to detect time sequences of sensor signals of the at least one strain gauge (5, 6; 23a, 23b) and to evaluate time-related signal patterns in the time sequences of sensor signals.

## Description

The invention relates to a device for detecting actuating operations on motor vehicles. In particular, the invention relates to a device with an actuation element which is arranged on the motor vehicle so as to be accessible to a user. The actuation element may in particular be arranged on the motor vehicle as a handle or grip or actuating surface. The device has a sensor arrangement which is coupled to an evaluation device. The evaluation device receives signals from the sensor arrangement and, depending on the signals from the sensor arrangement, generates an actuation signal which is forwarded to the control systems of the motor vehicle.

The sensor arrangement is positioned on the actuation element in order to detect a deformation of the actuation element during an actuation. If a user exerts a force on the actuation element, this leads to a deformation of the actuation element, which is converted into sensor signals by the sensor arrangement and output to the evaluation device. If the evaluation device detects a user actuation on the basis of these sensor signals, it outputs a corresponding actuation signal.

Numerous devices for actuation detection on motor vehicles are known from the prior art. For example, capacitive sensors are arranged on door handles to detect the contactless approach of a user to a door handle. Systems are also known in which the deformation of actuation elements on vehicles is detected, whereby the deformation is usually detected by means of inductive sensors which detect the distance of a sensor arrangement to a metallic object arranged in objection.

EP 3439178 A1 discloses a corresponding device. There, inductive sensors are designed as printed conductor coils on a printed circuit board which interact with metallic components arranged on the handle housing. When the handle housing is deformed, the distance between the inductive sensors and the metallic components is changed and an actuation is detected.

The object of the invention is to improve the present devices for detecting actuation operations on motor vehicles and to extend their possible applications.

The task is solved by a device according to claim 1 and a method having the features of claim 10.

According to the invention, the sensor arrangement has at least one strain gauge which is arranged and fixed to the actuation element in order to detect deformations of the actuation element and to output sensor signals to the evaluation device.

Strain gauges are well-established measuring devices for detecting deformations. Strain gauges usually have meander-shaped conductor tracks that are arranged between two contact points on a support (e.g. an adhesive foil). If the support together with the conductor tracks is applied to a substrate, in this case the actuation element, a deformation of the substrate is also imposed on the support and the conductor tracks. As a result, the conductor paths are stretched or compressed and the electrical resistance of the conductor paths changes due to the change in length and the deformation of the conductor paths. The change in resistance is converted into a signal by a downstream electrical circuit, such as a Wheatstone bridge circuit. In the context of the present invention, such a circuit may be part of the evaluation device or may be interposed as a separate component between the sensor device and the evaluation device.

In principle, any commercially available strain gauge can be used within the scope of the invention. Usually, strain gauges which are available on the market at low cost consist of a support foil, a conductor arrangement of the above-mentioned type in loop or meander form arranged thereon and a cover foil. Such a strain gauge can easily be arranged at any point on an actuation element and bonded there over its entire surface in a functionally suitable manner.

According to the invention, the evaluation device is designed to detect time sequences of sensor signals of the at least one strain gauge and to evaluate time signal patterns.

The evaluation device monitors the sensor signals of the strain gauge not only for exceeding a threshold value or a specific trigger threshold, but rather time sequences of signals of the strain gauge are monitored in order to also detect more complex signal sequences and assign them to an actuation signal. This has the advantage that not only one type of actuation of the actuation detection device is possible, but different types of actuation can be distinguished depending on a detected time-resolved signal pattern. For example, an user can trigger different functions by the spatial placement and temporal sequence of his or her actuation on the actuation element. This enables an operation/actuation similar to the gesture control known from other actuation concepts. The positioning and temporal sequence of the interaction of the user with the actuation element is detected by the evaluation device on the basis of the signals of the at least one strain gauge and converted accordingly into an actuation signal.

If an user touches the actuation element, the touch and corresponding deformation lead to corresponding sensor signals. For example, pulling on the actuation element will generate a temporally extended sensor signal, while tapping on the actuation element will generate a temporal series of short increasing and decreasing resistance changes and sensor signals. The evaluation device monitors the signals of the at least one strain gauge until a signal sequence is detected that corresponds to a stored pattern and can thus be assigned to an actuation request. If such an assignment is made by the evaluation device, the evaluation device outputs a corresponding actuation signal at a signal output of the evaluation device. Downstream systems in the vehicle then trigger the corresponding function or carry out further checks, e.g. an authorisation check.

The evaluation of time resolved signal sequences can be carried out, for example, in such a way that the evaluation device temporarily stores sensor signals in a buffer memory and carries out pattern recognition on the basis of the stored signal sequence. The signal template patterns for an actual actuation gesture can be determined empirically by recording the signal sequences of the at least one strain gauge during operation in accordance with a specific actuation pattern and storing them as template patterns in the evaluation device.

The comparison data can be stored in a read-only memory of the evaluation device in order to assign temporal sensor signals to a specific operating instruction. The evaluation device can also teach-in and store such signals in a user-specific learning mode. Simple, characteristic signal sequences can be permanently stored in the evaluation device by the manufacturer, e.g. a longer (e.g. 0.5 s - 2 s) pulling of the actuation element or a longer pressing of the actuation element. Such pulling or pressing actuation movements lead to a deformation of the at least one strain gauge strip over longer periods of time, namely until the acting force is released again and the actuation element deforms back into its rest position. During this time, the evaluation device detects a change in resistance and can record the duration of the actuation as well as a measure of the acting force and the direction of the force. A further actuation, for example a tap on the actuation element, leads to a momentary change in the resistance of the at least one strain gauge and a sequence of such momentary actuations can be associated with a further actuation and lead to the output of a further actuating signal at the signal output of the evaluation device.

In a preferred embodiment of the invention, the sensor arrangement has at least two strain gauges arranged on the actuation element for detecting deformations in different spatial directions.

The use of at least two strain gauges arranged in different spatial directions relative to each other enables even more extensive evaluation of the effect of an operation on the actuation element. This means that even more complex actuation actions can be detected. The arrangement in different spatial directions means that actuations that lead to deformations of the actuation element and are not detected by one of the strain gauges are also detected by the other strain gauge. The evaluation device detects the temporal signal characteristics of all strain gauges and evaluates them together to recognise the respective characteristic signal characteristics in order to generate an actuation signal from the totality of the recognised characteristic signal characteristics.

It is preferable to provide a minimum evaluation time during which the temporal signal curves of the strain gauges are monitored before the evaluation device makes an assignment to an actuation signal.

By providing a minimum evaluation time period, which, as described below, can be adjusted if necessary in the course of the measurements, more complex actuating operations can also be detected and a premature determination of an actuating signal before the actual completion of an actuating operation can be avoided.

In this context, it is preferred if the minimum evaluation time duration is determined for each detection of a temporal signal pattern by the evaluation device as a function of at least one sensor signal detected at the beginning of the respective evaluation event.

In such a case, the evaluation device detects at the beginning of an evaluation event that an evaluation event could start because the sensor signals of at least one strain gauge deviate from their rest value. Depending on the level and duration of these first signals, the evaluation device determines whether a longer or shorter period of time should be dedicated to the evaluation. This determination is made on the basis of the sensor signals detected up to this point. If, for example, a certain, simple time-resolved signal series is provided for a frequent standard actuation, the minimum evaluation time can be shortened compared to a predetermined standard value. If such an actuator is used, for example, in a door handle and it is envisaged that a pressing down of the door handle is required to open the door, then when a temporal signal pattern is detected which signals a pressing down of the actuator on the door handle, a corresponding actuating signal can be output quickly in order to shorten the time delay until the door is opened. This is particularly useful if no further operating gesture is provided that begins with the pressing down of the door handle. If, on the other hand, a signal sequence is received at the beginning of an actuation which could be the beginning of a more complex operating gesture, the minimum evaluation time duration is determined in such a way that sufficient time is available for the execution of this gesture.

In a particularly preferred embodiment of the invention, the actuation element comprises at least two actuation sections that are angled with respect to each other.

The use of actuation sections angled relative to one another enables, on the one hand, particularly convenient handling by a user and, on the other hand, a particularly flexible and spatially adapted arrangement of the strain gauges depending on which actuations are intended from which directions.

It is preferred that at least one strain gauge is arranged on each of at least two of the actuation sections angled towards each other. With this arrangement, the strain gauges are necessarily given different spatial orientations, since the angled actuation sections have different spatial orientations to one another. Based on the respective signal curves, it can then be determined on which section of the angled actuation sections a stretching or compressing force is currently acting.

In a preferred embodiment of the invention, the actuation element of the device is formed with an inner support structure which is formed from an elastic material, in particular a metal. A strain gauge is applied to the inner support structure and the inner support structure is covered, at least in sections, by a cover structure or cover layer which also covers the strain gauge.

In this design, the strain gauge is protected from environmental influences and the support structure consisting of the elastic material ensures that the strain gauge is stretched with forces distributed over the strip and, on the other hand, that it returns to the unaffected rest position at each time.

The formation of the support structure from a metallic material ensures stability and also thermal homogeneity along the strain gauge strip. The formation of a cover structure from a plastic material improves the feel of the actuation element for a user and, on the other hand, is easy to clean and resistant to environmental influences.

In a further embodiment of the invention, the actuation element is formed as a flat or curved cover of an actuation device, wherein at least two strain gauges are arranged on the inside of the actuation element.

Such devices can be arranged, for example, in the rear portion of a vehicle, there, for example, in the form of a vehicle emblem which simultaneously serves as a actuation device for actuating the tailgate.

By arranging the strain gauges in different spatial directions, the actuation positions along different parts of the cover can also be distinguished. Depending on the location of the force application, different temporal signal progressions and signal strengths of the sensor signals are detected by the evaluation device. Based on these time-related sensor signal progressions, it can be recognised in which outer area of the cover the actuation actually takes place.

In a method according to the invention for detecting actuations on a motor vehicle, a deformation of an actuation element on a motor vehicle is first detected with at least one strain gauge. Subsequently, the time sequence of signals of the strain gauge is detected with an evaluation device. Characteristic temporal signal sequences are then identified in the temporal sequence of the signals of the strain gauge by the evaluation device. The identified characteristic temporal signal sequences are assigned actuation signals by the evaluation device and the actuation signal is output at the signal output of the evaluation device.

Preferably, the method takes into account two or more strain gauges, for each of which characteristic temporal signal sequences are identified.

Preferably, the method according to the invention is carried out with a device according to the above description.

The invention will now be explained in more detail with reference to the accompanying drawing.
Figure 1 shows a schematic, perspective view of a first embodiment of the invention;
Figure 2 shows a schematic sectional view of the embodiment of Figure 1;
Figure 3a shows exemplary first signal characteristics of the strain gauges from the first embodiment in the course of a first operation;
Figure 3b shows exemplary second signal characteristics of the strain gauges from the first embodiment in the course of a second operation;
Figures 4a and 4b show perspective views of a second embodiment of the invention;
Figure 4c shows an exploded view of the second embodiment;
Figure 4d schematically shows the arrangement of the strain gauges on the second embodiment;

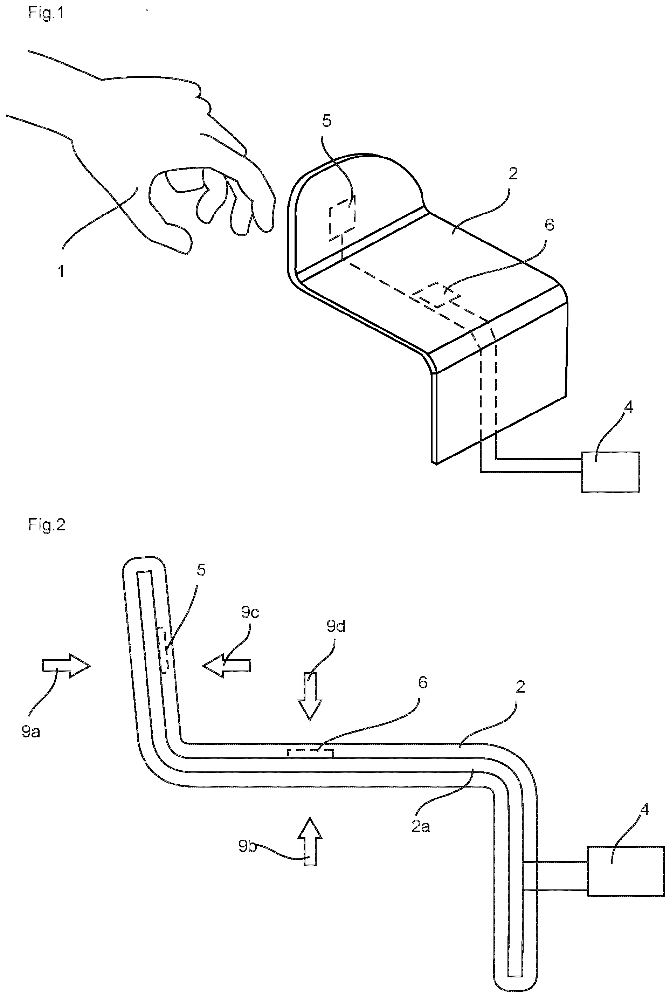

Figure 1 shows a first embodiment of a device for detecting actuation on motor vehicles. The device comprises an actuation element 2, which in this embodiment has three sections angled towards each other. An end section facing a user 1 is angled upwards so that a user 1 can easily reach over and pull or push this section. A horizontal section is formed as a middle section and connects the end sections. An end section on the vehicle side is again angled and provides a mounting surface for attachment to a motor vehicle.

Strain gauges 5 and 6 are arranged on the actuation element 2, with the strain gauge 5 being arranged on the user-side upright end portion of the actuation element 2. The strain gauge 6 is arranged on the middle section of the actuation element 2. A evaluation device 4 is coupled to the strain gauges 5 and 6, which receives the signals of the respective strain gauges and evaluates time-related signal characteristics. The respective electrical resistances are evaluated as a measure of the deformation of the strain gauges. The conversion of the resistance change into a measured value can be done, for example, by a Wheatstone bridge circuit, but any other circuits or logic components can also be used to detect the resistance change.

Figure 2 shows a schematic side cross-section of the first embodiment. Here it is shown that the actuating element 2 has a core 2a which is formed from an elastic, metallic material. This core is surrounded by a plastic casing. The strain gauges 5 and 6 are glued to the core 2a made of the elastic metallic material. The strain gauges 5 and 6 are encased and protected by the plastic material. Figure 2 shows different directions of force 9a, 9b, 9c and 9d from which the actuating forces can act on the actuating element 2. Depending on the force applied, the strain gauges 5 and 6 generate different signal patterns with a characteristic time pattern. If, for example, a user 1 pulls or pushes on the protruding, end section of the actuation element 2, the strain gauges 5 and 6 register corresponding deformations. A knock against this section or a sequence of such knocks leads in the course of time to other sensor signals which are detected by the evaluation device 4.

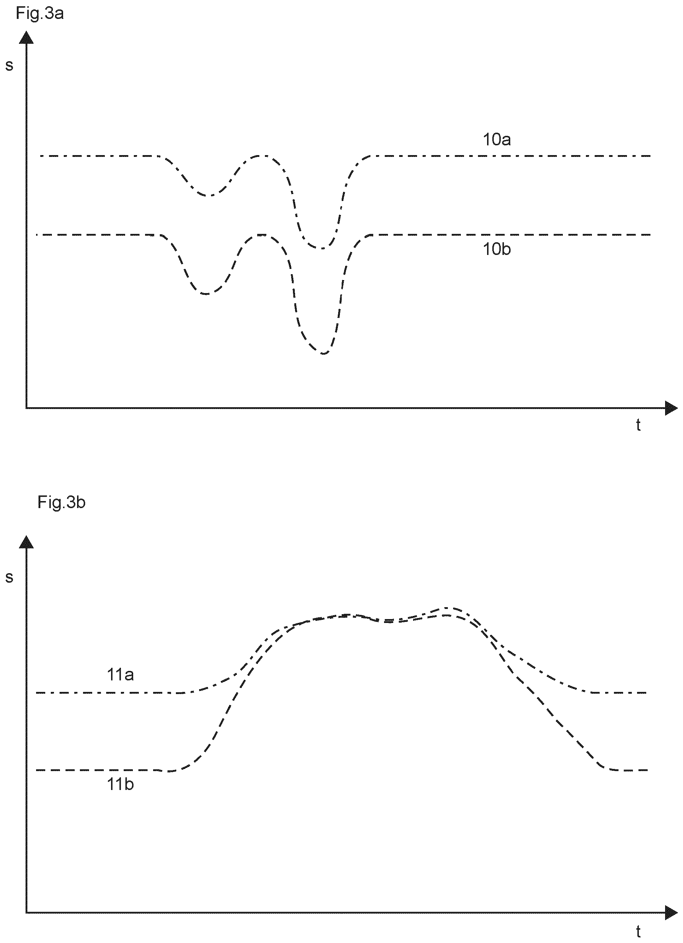

Figures 3a and 3b show exemplary signal characteristics of the strain gauges 5 and 6 as recorded and evaluated by the evaluation device 4. In Figure 3a, the signal waveform 10a shows an example of the signal curve of the strain gauge 6 over time, while the signal curve 10b shows an example of the signal curve of the strain gauge 5. The signal curve shown in Figure 3a is characteristic of an user 1 who strikes the actuation element 2 twice in succession, for example on the side of the user-side end section (direction of arrow 9a in Figure 2). The evaluation device 4 detects two significant signal deflections in quick succession and can assign a desired operating action and thus an actuation signal to this operating gesture, which the evaluation device 4 outputs at its signal output on the output side. The signal pattern can be recognised, for example, by pattern matching with stored signal curves. By including two strain gauges in the evaluation, the evaluation device 4 can also check the consistency of the sensor signals so that false detections in the case of inconsistent sensor data are avoided.

Figure 3b shows the signal characteristics of the strain gauges 5 and 6 for the same embodiment when the user pulls on the actuation element 2. In this case, the user 1 grips the actuation element 2 at its protruding end section and pulls on it (the force acts in the direction of the force arrow 9c in Figure 3). In this illustration it can be seen that the signal curves differ significantly from those in Figure 3a. In this example, signal 11a comes from strain gauge 6 and signal 11b from strain gauge 5. The signal variations are from rest in the opposite direction to the signal variations in Figure 3a. In addition, the pull on the actuation element 2 causes time-characteristic changes in the signals; short, separate signal pulses are now no longer recognisable, but both signal curves increase significantly over a longer period of time.

The evaluation device 4 assigns these signal characteristics to a different actuation gesture and thus to a different actuation request and generates a corresponding actuation signal that differs from the actuation signal generated in response to the signal characteristics of Figure 3A.

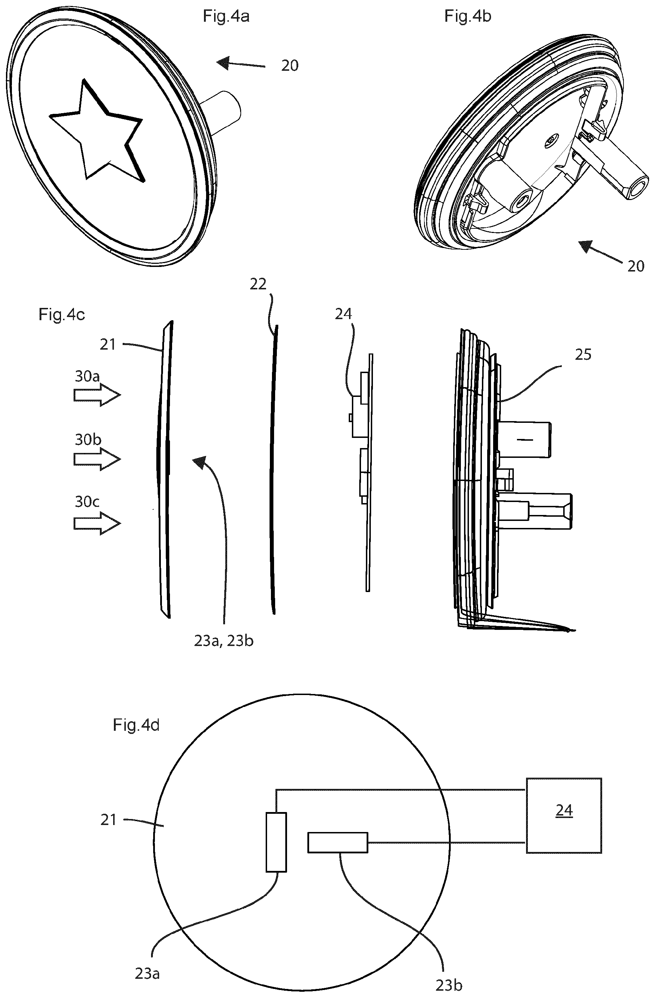

Figures 4a, 4b, 4c and 4d concern a second embodiment example.

In this embodiment example, the device 20 is housed in an actuation element which is arranged, for example, at the rear of a vehicle and is provided, for example, with a manufacturer's emblem.

Such a device can then serve, for example, as a control element for the tailgate of the vehicle. In this embodiment , the device has a housing 25, the cover 21 of which forms the actuation element of the device. The housing 25 houses a circuit board with electronic components, including the evaluation device 24. A seal 22 is arranged between the actuation element 21 and the housing 25.

The housing 25 has mounting sections with which it can be secured to the vehicle in its installed position so that the actuation element 21 faces outwards for interaction with a user.

Figure 4d shows strain gauges 23a and 23b which are arranged on the inside of the cover 21 in different spatial directions in relation to each other and are coupled to the evaluation device 24 for signal output. The decentralised arrangement of the strain gauges 23a and 23b and their orientation makes it possible to distinguish the application of actuation forces to different sections of the actuation element 21. The arrows 30a, 30b and 30c show different actions at different positions of the actuation element 21, which are converted into different signal responses of the strain gauges 23a and 23b. The evaluation device 24 detects the signals and in turn concludes a actuation signal by pattern matching with stored temporal pattern progressions. Accordingly, the evaluation device 24 then transmits the command signal to the vehicle's downstream systems. In addition to a determination of the user's position possible through the alignment of the strain gauges 23a and 23b, temporal differentiations are again possible, as shown in the first embodiment example. For example, an user can express a first actuation request by tapping the actuation element 21 once or several times, while pressing the actuation element 21 for a longer period expresses a different actuation request.

## Claims

1. Device for detecting an actuating action on motor vehicles,
the device having an actuation element (2; 21), a sensor arrangement and an evaluation device (4; 24) which is coupled to the sensor arrangement and outputs an actuation signal as a function of signals from the sensor arrangement,
the sensor arrangement being arranged on the actuation element (2; 21) in order to detect a deformation of the actuation element (2; 21) during an actuation,
the sensor arrangement comprising at least one strain gauge (5, 6; 23a, 23b) which is fixed to the actuation element in order to detect deformations,
**characterized in that**
the evaluation device (4; 24) being designed to detect time sequences of sensor signals of the at least one strain gauge (5, 6; 23a, 23b) and to evaluate time-related signal patterns in the time sequences of sensor signals,
the evaluation device (4; 24) for evaluating the time-related signal patterns detects for each evaluation event the sensor signals at least over a predetermined minimum evaluation time comprising a plurality of time-resolved sensor signals and evaluates the sensor signals during this minimum evaluation period,
wherein the predetermined minimum evaluation period for each detection of a time-related signal pattern is determined by the evaluation device (4; 24) as a function of a plurality of time-resolved sensor signals from at least one strain gauge (5, 6; 23a, 23b) which is detected at the beginning of the respective evaluation event.

2. Device according to claim 1, wherein the sensor arrangement has at least two strain gauges (5, 6; 23a, 23b) being fixed to the actuation element (2; 21) and being arranged in different spatial directions for detecting deformations on the actuation element (2; 21).

3. Device according to any one of the preceding claims, wherein the actuation element (2) has at least two actuation sections which are angled with respect to one another.

4. Device according to claim 3, wherein at least one strain gauge (5, 6) is arranged on each of at least two of the mutually angled sections of the actuation element (2).

5. Device according to any one of the preceding claims, wherein the actuation element has an inner support structure (2a) made of an elastic material, to which the at least one strain gauge (5, 6) is attached, and wherein the inner support structure (2a) is covered at least in sections by a cover structure or cover layer which covers the strain gauge.

6. Device according to claim 5, wherein the inner support structure (2a) is formed of a metallic material and wherein the cover structure is formed of a plastic.

7. Device according to any one of claims 1 to 2, wherein the actuation element (21) is formed as a flat or curved cover of an actuation device, wherein at least two strain gauges (23a, 23b) are fixed on the inside of the actuation element, which strain gauges are arranged in different spatial directions for detecting deformations on the actuation element (21).

8. Method for detecting operations on a motor vehicle, carried out with a device according to any one of claims 1 to 7 and having the steps:
Detecting a deformation of an actuation element (2; 21) on a motor vehicle with at least one strain gauge (5, 6; 23a, 23b) ;
Acquisition of a time sequence of signals of the strain gauge (5, 6; 23a, 23b) with an evaluation device (4; 24);
Identifying characteristic time-related signal patterns in the time sequence of signals of the strain gauge (5, 6; 23a, 23b) by the evaluation device (4; 24);
Assigning an actuation signal to the identified characteristic time-related signal patterns by the evaluation device (4; 24);
outputting the assigned actuation signal by the evaluation device at a signal output of the evaluation device.
